# EUROPÄISCHE PATENTANMELDUNG

(11) **EP 2 315 040 A2**
(43) Veröffentlichungstag der Anmeldung: **27.04.2011**
(21) Anmeldenummer: 10187357.8
(22) Anmeldetag: 13.10.2010
(51) Int. Cl.: G01R 11/04

(54) **Elektrizitätszähler**

(30) Priorität: 21.10.2009 DE 102009050184
(71) Anmelder: Zintl, Peter, 93098 Mintraching (DE)
(72) Erfinder: Zintl, Peter, 93098 Mintraching (DE)
(74) Vertreter: Bittner, Bernhard

(57) **Zusammenfassung**

Eine Vorrichtung (1) zum Messen eines elektrischen Energieverbrauchs mit wenigstens zwei elektrischen Anschlüssen (4, 6) zum Anschließen an eine elektrische Versorgung, mit wenigstens einer Informationsausgabeeinrichtung (8) zum Ausgeben von Informationen, welche für die an der Vorrichtung angeschlossene Versorgung charakteristisch sind, an den Benutzer und mit wenigstens einer Wandlereinrichtung zum Wandeln von analogen Signalen in digitale Signale Erfindungsgemäß weist die Vorrichtung ein Basisteil (12) auf, sowie ein mit diesem Basisteil (12) verbindbares und von diesem Basisteil (12) lösbares Prozessorteil (14), und eine elektrische und lösbare Verbindungseinrichtung (18) zwischen dem Basisteil (12) und dem Prozessorteil (14), wobei die elektrischen Anschlüsse an dem Basisteil (12) und die Informationsausgabeeinrichtung (8) in dem Prozessorteil (14) angeordnet sind.

## Beschreibung

Die vorliegende Erfindung bezieht sich auf eine Vorrichtung zum Messen eines elektrischen Energieverbrauchs und insbesondere auf einen Elektrizitätszähler für Personenhaushalte. Derartige Elektrizitätszähler, im Folgenden auch kurz als Stromzähler bezeichnet, sind aus dem Stand der Technik seit langem bekannt. Dabei sind aus dem Stand der Technik sowohl analoge bzw. auf elektromechanischem Prinzip basierende Stromzähler als auch elektronisch arbeitende Stromzähler bekannt.

Weiterhin sind auch die unterschiedlichsten Befestigungsmöglichkeiten für derartige Stromzähler bekannt. So ist beispielsweise eine Dreipunktbefestigung nach DIN 43857 aus dem Stand der Technik bekannt oder eine Befestigung, bei der ein Gehäuse eingehakt wird und mehrere Kontakte für Stromzugänge und -abgänge als Steckkontakte ausgeführt sind. Schließlich ist auch ein DIN-Hutschienengehäuse bekannt, welches Kontaktklemmen zum Anschließen von elektrischen Anschlüssen wie insbesondere Dreiphasenanschlüssen für die Eingänge, Dreiphasenanschlüsse für die Ausgänge und einen Nullkontakt aufweist. Damit existieren auf dem Markt mehrere unterschiedliche Typen von Stromzählern, die miteinander nicht kompatibel sind.

Insbesondere moderne elektronische Elektrizitätszähler weisen dabei sowohl Bauteile auf, welche eine längere Lebenserwartung haben als auch solche Bauteile, welche eine kürzere Lebenserwartung haben. Die Lebensdauer des Geräts in seiner Gesamtheit richtet sich jedoch nach denjenigen Bauteilen, welche die kürzere Lebensdauer aufweisen, insbesondere die D/A Wandler, Flüssigkristallanzeigen und dergleichen.

Der vorliegenden Erfindung liegt die Aufgabe zugrunde, die Fertigungskosten für derartige Stromzähler bei Beibehaltung der Variabilität zu senken.

Diese Aufgabe wird erfindungsgemäß durch den Gegenstand des unabhängigen Patentanspruchs erreicht. Vorteilhafte Ausführungsformen und Weiterbildungen sind Gegenstand der Unteransprüche.

Eine erfindungsgemäße Vorrichtung zum Messen eines elektrischen Energieverbrauchs weist wenigstens zwei elektrische Anschlüsse zum Anschließen einer elektrischen Versorgung auf, sowie wenigstens eine Informationsausgabeeinrichtung zum Ausgeben von Informationen, welche für die an der Vorrichtung angeschlossene Versorgung charakteristisch sind. Daneben ist wenigstens eine Wandlereinrichtung zum Wandeln von analogen in digitale Signale vorgesehen.

Erfindungsgemäß weist die Vorrichtung ein Basisteil, sowie ein mit diesem Basisteil verbindbares und von diesem Basisteil lösbares Prozessorteil und eine elektrische und lösbare Verbindungseinrichtung zwischen dem Basisteil und dem Prozessorteil. Dabei sind die elektrischen Anschlüsse an dem Basisteil und die Informationsausgabeeinrichtung in dem Prozessorteil angeordnet.

Es wird damit vorgeschlagen, die erfindungsgemäße Vorrichtung zweiteilig auszubilden, nämlich als das erwähnte Basisteil und das Prozessorteil. Unter Informationen, welche für die in der Vorrichtung angeschlossene Versorgung charakteristisch sind, werden insbesondere Informationen über den aktuellen Stromverbrauch, einem kumulierten Stromverbrauch und dergleichen verstanden. Bei der Informationsausgabeeinrichtung handelt es sich insbesondere um eine Anzeigeeinrichtung wie Flüssigkristallanzeige, welche bevorzugt die gewünschten Werte in digitaler Form ausgibt. Es wäre jedoch auch die Verwendung anderer Anzeigen denkbar. Auch könnte es sich bei der Informationsausgabeeinrichtung um eine Schnittstelle oder dergleichen handeln, über welche Daten ausgegeben bzw. ausgelesen werden können. So wäre es möglich, dass die Vorrichtung (künftig) ohne unmittelbar ablesbare Anzeige auskommt.

Durch das erfindungsgemäße Konzept sind die Montageplätze für den Elektrizitätszähler so konzipiert, dass standardisierte Gehäuseformen montiert werden können. Es ist daher möglich, den elektronischen Teil, d. h. insbesondere das Prozessorteil in einer Gehäuseform zu realisieren, die unabhängig von dem verwendeten Grundgehäuse bzw. Basisteil verwendet werden kann. Es wird daher bevorzugt ein universelles Prozessorteil vorgesehen, welches mit unterschiedlichen Basisteilen verbunden sein kann. Dieses erwähnte Prozessorteil ist dabei vorteilhaft an einem universellen Gehäuse vorgesehen und unabhängig von dem erwähnten Basisteil. Auf diese Weise sind größere Fertigungsmengen und damit Kostenvorteile unabhängig von der von dem Kunden geforderten Grundform, insbesondere des Basisteils, möglich. Daneben ist auch eine unabhängige bzw. getrennte Eichung der beiden Komponenten Basisteil und Anzeigteil bzw. universelles Geräteteil möglich.

Vorteilhaft weist das Basisteil eine Befestigungseinrichtung zum Befestigen des Basisteils an einem Träger auf. Dieses Befestigungsteil kann dabei unterschiedlich ausgeführt sein. Dabei kann es sich beispielsweise um Eingriffsmittel in eine Hutschiene handeln, um eine Vielzahl von Kontaktstiften, welche in entsprechende Buchsen eingreifen, oder auch um eine oben erwähnte 3-Punktaufhängung. Diese Befestigungseinrichtung kann dabei unterschiedlich ausgeführt sein, je nach den Wünschen eines Kunden.

Vorteilhaft weist das Basisteil wenigstens ein erstes elektrisches Bauelement auf. Dieses erste elektrische Bauelement ist dabei insbesondere aus einer Gruppe von Bauelementen ausgewählt, welche Widerstände, Spulen und dergleichen enthält. Vorteilhaft enthält damit das Basisteil bzw. Grundgehäuse den elektromechanischen Teil eines Stromzählers.

Vorteilhaft weist das Prozessorteil wenigstens ein zweites elektrisches Bauelement auf. Insbesondere ist dieses zweite elektrische Bauelement aus einer Gruppe von Bauelementen ausgewählt, welche Kondensatoren, elektronische Schaltkreise, Halbleiterbauelemente und dergleichen enthält. Damit enthält das Prozessorteil insbesondere den elektronischen Teil eines Strom- bzw. Elektrizitätszählers.

Vorteilhaft ist die durchschnittliche Lebenszeit wenigstens eines elektrischen Bauelements höher als die durchschnittliche Lebenszeit wenigstens eines zweiten elektrischen Bauelementes. Damit ist es möglich, dass das Basisteil und das Prozessorteil unabhängig voneinander geeicht werden können. Auch ist es möglich, dass das Basisteil und das Prozessorteil unterschiedliche Eichzeiten aufweisen und insbesondere das Basisteil eine längere Eichzeit aufweist als das Prozessorteil. Auf diese Weise können insgesamt die Montage-, Reparatur- und Wechselkosten für derartige Stromzähler reduziert werden.

Vorteilhaft weisen die ersten Bauelemente, welche in das Basisteil integriert sind, jeweils eine höhere Lebenszeit auf als die zweiten Bauelemente, welche in das Prozessorteil integriert sind. Insbesondere werden die länger lebenden Bauteile in das Basisteil integriert.

Bei den ersten Bauelementen handelt es sich insbesondere um passive Bauelemente und bei den zweiten Bauelementen um aktive Bauelemente.

Bei einer weiteren vorteilhaften Ausführungsform ist die elektrische Verbindungseinrichtung derart ausgebildet, dass das Prozessorteil in eindeutiger Weise mit dem Basisteil verbindbar ist. Auf diese Weise kann auch durch Laien das Prozessorteil an ein Basisteil angeschlossen werden.

Bei einer weiteren vorteilhaften Ausführungsform weist wenigstens das Basisteil oder das Prozessorteil ein Gehäuse auf, wobei in diesem Gehäuse jeweils wenigstens ein elektrisches Bauelement angeordnet ist. Insbesondere ist sowohl das Basisteil als auch das Prozessorteil jeweils mit einem Gehäuse ausgebildet und diese Gehäuse sind miteinander (insbesondere auch elektrisch) verbindbar.

Bei einer weiteren vorteilhaften Ausführungsform ist die Vorrichtung wenigstens teilweise aus einem Duroplast hergestellt, der bevorzugt aus einem nachwachsenden Rohstoff gewinnbar ist. Es wird darauf hingewiesen, dass diese Ausführungsform auch unabhängig von der oben erwähnten Erfindung anwendbar ist, d. h. es wäre auch möglich, einen konventionellen Elektrizitätszähler wenigstens teilweise aus einem Duroplast herzustellen. Insbesondere sind die oben erwähnten Gehäuse aus einem Duroplast hergestellt, der bevorzugt aus einem nachwachsenden Rohstoff gewinnbar ist. Die aus dem Stand der Technik bekannten Elektrizitätszähler werden aus Kunststoffen und vorwiegend Bakelit oder Polycarbonat gefertigt. Die Gehäuse werden dabei üblicherweise in einem Spritzgussverfahren hergestellt. Aus diesem Grunde müssen nicht mehr eingesetzte Stromzähler entsprechend den gesetzlichen Vorschriften entsorgt werden.

Eine Aufgabe der vorliegenden Erfindung besteht darin, die Gehäusekomponenten oder anderer Bestandteile der Stromzähler mit Duroplasten aus nachwachsenden Rohstoffen zu fertigen. Dabei genügt das verwendete Material bevorzugt den technischen Anforderungen insbesondere den Umweltprüfungen, den EMV-Prüfungen (elektro-magnetische Verträglichkeit) für die Zulassungsfähigkeit der jeweiligen Geräte. Vorteilhaft ist das verwendete Material 100%ig biologisch abbaubar und kann wie die heutig verwendeten Materialien im Spritzgussverfahren verarbeitet werden. Der Vorteil dieses Materials besteht darin, dass es aus nachwachsenden Rohstoffen besteht und dass es gegen Hitze und Entflammbarkeit widerstandfähig ist. Dabei ist vorteilhaft das Gerät sowohl als Basisgerät d. h. Basisteil und Prozessorteil verwendbar als auch in der Verwendung mit erweiterten Modulen. Diese Erweiterungsmodule können dabei kundenorientiert ausfallen bzw. gemäß gesetzlichen Anforderungen und gemäß der technologischen Entwicklung.

Vorteilhaft weist die erfindungsgemäße Vorrichtung eine Echtzeituhr auf und besonders bevorzugt auch ein Signatursystem.

Weitere Vorteile und Ausführungsformen ergeben sich aus den beigefügten Zeichnungen:
Darin zeigen:
   - Fig. 1: eine Darstellung verschiedener Kombinationen zwischen Basisteilen und Prozessorteilen;
   - Fig. 2: eine Anordnung einer erfindungsgemäßen Vorrichtung an einem Schaltschrank; und
   - Fig. 3: eine Darstellung zur Veranschaulichung der elektronischen Bauelemente der erfindungsgemäßen Vorrichtung.

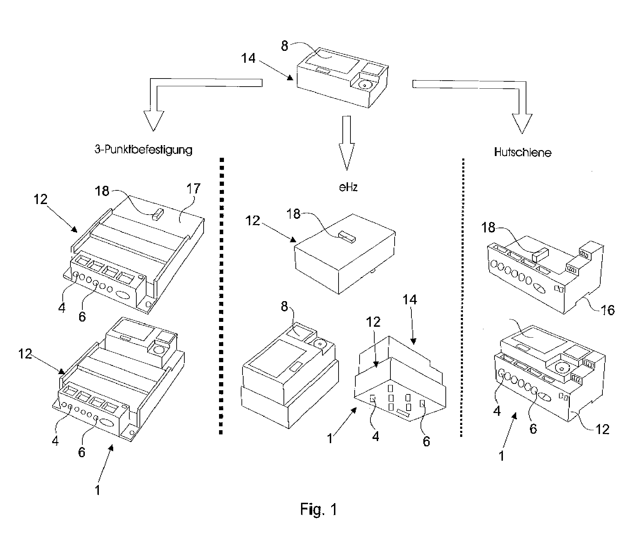

Fig. 1 zeigt eine Darstellung einer erfindungsgemäßen Vorrichtung. Diese Vorrichtung 1 weist dabei ein (einheitliches) Prozessorteil 14 auf, welches mit unterschiedlichen Basisteilen 12 verbunden werden kann. Diese Basisteile 12 weisen dabei unterschiedliche Befestigungsmechanismen zur Befestigung an Trägern auf. Daneben weisen diese Basisteile 12 auch jeweils unterschiedliche Kontaktmöglichkeiten zum Anschluss elektrischer Verbindungsleitungen und insbesondere elektrischer Ein- und Ausgänge auf.

So ist beispielsweise das links dargestellte Basisteil 12 für eine 3-Punktbefestigung geeignet und weist Anschlüsse 4 und 6 zum Anschluss an eine elektrische Versorgung auf. Dieses Basisteil 12, welches für die 3-Punktbefestigung geeignet ist, kann beispielsweise auf einer Zählertafel montiert werden. Das Prozessorteil bzw. Steckteil 14 ist dabei auf das Basisteil 12 aufsteckbar. Das Bezugszeichen 18 kennzeichnet ein elektrisches Verbindungsmittel, welches einen elektrischen Kontakt zwischen dem Basisteil 12 und dem Prozessorteil 14 herstellt. Weiterhin weist das Basisteil 12 eine hier glatt ausgebildete Oberfläche 17 auf und das Prozessorteil 14 eine ebenfalls entsprechend glatt ausgebildete Fläche. Auf diese Weise wird ein flächiger Kontakt zwischen dem Basisteil 12 und dem Prozessorteil 14 hergestellt.

Das Basisteil 12 ist derart ausgestaltet, dass das Prozessorteil 14 nur in einer vorgegebenen Weise auf dem Basisteil montiert werden kann, wie in dem unteren linken Bild dargestellt. Auf diese Weise kann eine Fehlkontaktierung vermieden werden.

In der mittleren Darstellung ist ein weiteres Basisteil 12 dargestellt, welches beispielsweise nach dem Lastenheft für elektronische Haushaltszähler ausgebildet ist. Dieses kann an seiner Rückseite Einhakvorrichtung aufweisen, um entsprechend an einem Träger eingehakt zu werden. Auch hier kann das Prozessorteil 14 in eindeutiger Weise an dem Basisteil 12 befestigt werden. Die elektrischen Anschlüsse 4 und 6, bei denen es sich beispielsweise um drei Eingänge für drei Phasen handeln kann, sowie drei Ausgänge für drei Phasen und einen weiteren Nullkontakt sind hier an der Unterseite des Basisteils 12 angeordnet.

Auf der rechten Seite wird ein weiteres Basisteil 12 gezeigt, welches hier eine Aufnahmeausnehmung 16 zur Aufnahme einer Hutschiene aufweist. Dieses Basisteil 12 kann damit auf eine Hutschiene aufgeschoben werden. Jedoch weist auch dieses Basisteil 12 eine elektrische Verbindung 18 zum Anschluss des Prozessorteils auf. Bei den in Fig. 1 gezeigten Ausführungsformen des Basisteils ist jeweils ein flächiger Kontakt zwischen dem Basisteil und dem Prozessorteil möglich.

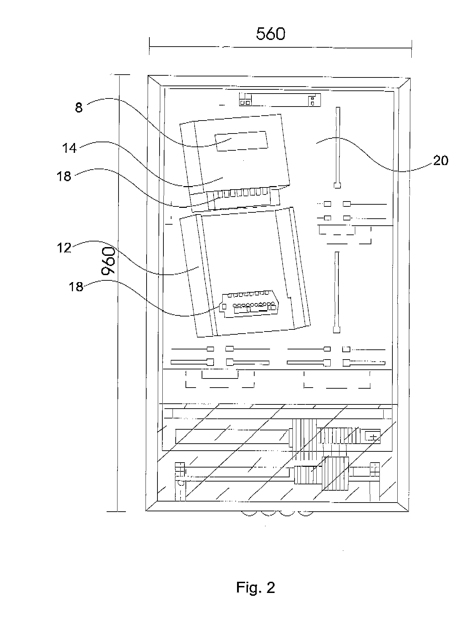

Fig. 2 zeigt eine Darstellung, bei der das Basisteil an einer Zählertafel 20 montiert ist. Das Prozessorteil 14 kann hier in das Basisteil eingesteckt werden, wobei an dem Basisteil seitliche Schienen bzw. Ränder vorgesehen sind, welche einen genauen Anschluss erlauben. Auf diese Weise ist eine Montage des Prozessorteils in das Basisteil ohne spezialisiertes Fachpersonal möglich. Daneben können wie erwähnt auch Montagefehler (hinsichtlich des Drehfeldes und der Stromein- und -ausgänge) vermieden werden.

So ist es möglich, dass die vorliegende Erfindung als ein Basisgerät mit reduzierter Funktionalität ausgeführt ist und Funktionserweiterungen (nicht gezeigt) durch externe Module bzw. Modulfunktionen möglich sind.

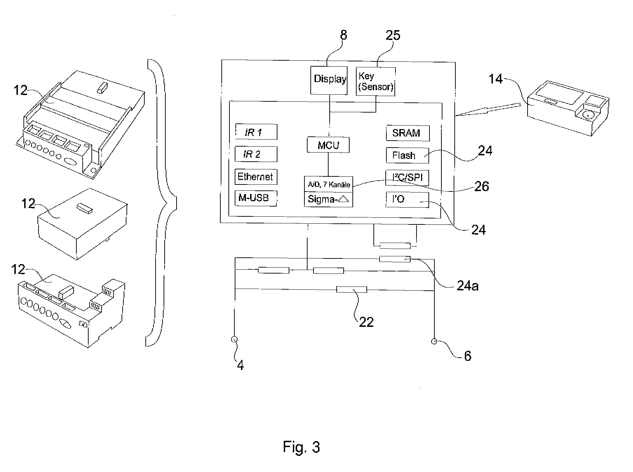

Fig. 3 zeigt eine weitere Darstellung einer erfindungsgemäßen Vorrichtung, wobei hier insbesondere auch die einzelnen elektronischen Bauelemente angezeigt sind. So kann es sich beispielsweise bei dem Bauelement 22 um einen Widerstand handeln, der eine bestimmte Spannung von einem Verbraucher abgreift. Das Bezugszeichen 22a kann beispielsweise eine Spulenanordnung darstellen, welche ebenfalls an dem Basisteil 12 angeordnet ist. Bei diesem elektrischen Bauteil handelt es sich insbesondere um längerlebige Bauteile, welche auch für längere Eichzeiten geeignet sein können. Das Bezugszeichen 24a bezieht sich hier auf einen analog-digital Wandler der siebenkanalig ausgeführt ist. Das Bezugszeichen 24 kennzeichnet weitere elektronische Bauteile, die eine geringere Lebenszeit aufweisen. Das Bezugszeichen 25 kennzeichnet eine Sensoreinrichtung, die beispielsweise eine manuelle Eingabe eines Benutzers erfassen kann.

Auf diese Weise sind in dem Prozessorteil 14 diejenigen elektrischen Bauelemente integriert, welche kürzerlebig ausgeführt sind. Auf diese Weise können für das Basisteil 12 und das Prozessorteil 14 unterschiedliche Eichzeiten vorgegeben werden.

Sämtliche in den Anmeldungsunterlagen offenbarten Merkmale werden als erfindungswesentlich beansprucht, sofern sie einzeln oder in Kombination gegenüber dem Stand der Technik neu sind.

### Bezugszeichenliste

- 1: Vorrichtung
- 4, 6: Anschlüsse
- 12: Basisteil

- 14: Prozessorteil
- 16: Aufnahmeausnehmung
- 17: Oberfläche
- 18: Verbindungsmittel
- 20: Zählertafel
- 22: Bauelement
- 22a: Spulenanordnung
- 24: elektronische Bauteile
- 24a: analog-digital Wandler
- 25: Sensoreinrichtung

## Patentansprüche

1. Vorrichtung (1) zum Messen eines elektrischen Energieverbrauchs mit wenigstens zwei elektrischen Anschlüssen (4, 6) zum Anschließen an eine elektrische Versorgung, mit wenigstens einer Informationsausgabeeinrichtung (8) zum Ausgeben von Informationen, welche für die an der Vorrichtung angeschlossene Versorgung charakteristisch sind, an den Benutzer und mit wenigstens einer Wandlereinrichtung zum Wandeln von analogen Signalen in digitale Signale
**dadurch gekennzeichnet, dass**
die Vorrichtung ein Basisteil (12) aufweist, sowie ein mit diesem Basisteil (12) verbindbares und von diesem Basisteil (12) lösbares Prozessorteil (14), und eine elektrische und lösbare Verbindungseinrichtung (18) zwischen dem Basisteil (12) und dem Prozessorteil (14), wobei die elektrischen Anschlüsse an dem Basisteil (12) und die Informationsausgabeeinrichtung (8) in dem Prozessorteil (14) angeordnet sind.

2. Vorrichtung nach Anspruch 1,
**dadurch gekennzeichnet, dass**
das Basisteil (12) eine Befestigungseinrichtung (16) zum Befestigen des Basisteils (12) an einem Träger (20) aufweist.

3. Vorrichtung nach wenigstens einem der vorangegangenen Ansprüche,
**dadurch gekennzeichnet, dass**
das Basisteil (12) wenigstens ein erstes elektrisches Bauelement (22) aufweist.

4. Vorrichtung nach Anspruch 3,
**dadurch gekennzeichnet, dass**
das erste elektrische Bauelement (22) aus einer Gruppe von Bauelementen ausgewählt ist, welche Widerstände, Spulen und dergleichen enthält.

5. Vorrichtung nach wenigstens einem der vorangegangenen Ansprüche,
**dadurch gekennzeichnet, dass**
das Prozessorteil (14) wenigstens ein zweites elektrisches Bauelement (24) aufweist.

6. Vorrichtung nach Anspruch 5,
**dadurch gekennzeichnet, dass**
das zweite elektrische Bauelement (24) aus einer Gruppe von Bauelementen ausgewählt ist, welche Kondensatoren, elektronische Schaltkreise, Halbleiterbauelemente und dergleichen enthält.

7. Vorrichtung nach den Ansprüchen 3 und 5,
**dadurch gekennzeichnet, dass**
die durchschnittliche Lebenszeit wenigstens eines ersten elektrischen Bauelements (22) höher ist als die durchschnittliche Lebenszeit wenigstens eines zweiten elektrischen Bauelements (24)

8. Vorrichtung nach wenigstens einem der vorangegangenen Ansprüche,
**dadurch gekennzeichnet, dass**
die elektrische Verbindungseinrichtung (18) derart ausgebildet ist, dass das Prozessorteil (14) in eindeutiger Weise mit dem Basisteil (12) verbindbar ist.

9. Vorrichtung nach wenigstens einem der vorangegangenen Ansprüche,
**dadurch gekennzeichnet, dass**
wenigstens das Basisteil (12) oder das Prozessorteil (14) ein Gehäuse (32, 34) aufweist, wobei in diesem Gehäuse (32, 34) wenigstens ein elektrisches Bauelement angeordnet ist.

10. Vorrichtung nach wenigstens einem der vorangegangenen Ansprüche,
**dadurch gekennzeichnet, dass**
die Vorrichtung (1) wenigstens teilweise aus einem Duroplast hergestellt ist, der bevorzugt aus einem nachwachsenden Rohstoff gewinnbar ist.
